# EUROPEAN PATENT APPLICATION

(11) **EP 2 280 307 A1**
(43) Date of publication of application: **02.02.2011**
(21) Application number: 10170948.3
(22) Date of filing: 27.07.2010
(51) Int. Cl.: G03F 1/14

(54) **Pellicle for photolithography**

(30) Priority: 28.07.2009 JP 2009175251
(71) Applicant: Shin-Etsu Chemical Co., Ltd., Chiyoda-ku Tokyo (JP)
(72) Inventor: Shirasaki, Toru, Annaka-shi Gunma (JP)
(74) Representative: Vossius & Partner

(57) **Abstract**

A pellicle for lithography is provided that includes a pellicle frame, a pellicle film stretched over one end face of the pellicle frame, and a pressure-sensitive adhesive layer provided on the other end face, the pressure-sensitive adhesive layer having a bubble content of 10 to 90 volume %.

## Description

The present invention relates to a method for stripping a pellicle for lithography that is used as a debris shield for a lithographic mask when producing a liquid crystal display panel or a semiconductor device such as an LSI or a ULSI, and a stripping apparatus used therein.

In the production of a semiconductor such as an LSI or a VLSI or the production of a liquid crystal display panel, a pattern is formed by irradiating a semiconductor wafer or a liquid crystal substrate with light through an exposure master plate; if debris is attached to the exposure master plate used here, since the debris absorbs the light or bends the light, there are the problems that the replicated pattern is deformed, the edge becomes rough, or the background is stained black, thus impairing the dimensions, quality, appearance, etc. The 'exposure master plate' referred to in the present invention is a general term for lithographic masks and reticles.

These operations are usually carried out in a clean room, but even within a clean room it is difficult to always keep the exposure master plate clean, and a method is therefore employed in which a pellicle that allows exposure light to easily pass through is adhered to the surface of the exposure master plate to act as a debris shield.

The pellicle is basically constituted of a pellicle frame and a pellicle film stretched over the frame. The pellicle film is formed from nitrocellulose, cellulose acetate, a fluorine-based polymer, etc., which allows exposure light (g rays, i rays, 248 nm, 193 nm, etc.) to easily pass through. The pellicle film is adhered by coating the upper end part of the pellicle frame with a good solvent for the pellicle film and air-drying or by means of an adhesive such as an acrylic resin, an epoxy resin, or a fluorine resin. Furthermore, in order to mount a pellicle frame to an exposure master plate, a lower end part of the pellicle frame is provided with a pressure-sensitive adhesive layer made of a polybutene resin, a polyvinyl acetate resin, an acrylic resin, a silicon resin, etc. and a reticle pressure-sensitive adhesive protecting liner for the purpose of protecting the pressure-sensitive adhesive layer, which protecting liner is removed before mounting the pellicle frame.

The pellicle is installed so as to surround a pattern region formed on the surface of the exposure master plate. Since the pellicle is provided in order to prevent debris from becoming attached to the exposure master plate, this pattern region and a pellicle outer part are separated so that dust from the pellicle outer part does not become attached to the surface of the pattern.

In recent years, the LSI design rule has shrunk to sub-quarter micron, and accompanying this the wavelength of an exposure light source is being shortened, that is, instead of g rays (436 nm) and i rays (365 nm) from the hitherto predominant mercury lamp, a KrF excimer laser (248 nm), an ArF excimer laser (193 nm), etc. are being used. As shrinkage advances, the flatness required for the mask and the silicon wafer becomes more strict.

A pellicle is affixed to a mask in order to shield a pattern from debris after the mask is completed. When a pellicle is affixed to a mask, the mask flatness can sometimes change. When the mask flatness is degraded, as described above there is a possibility that a problem such as defocusing will occur. Furthermore, when the flatness changes, the pattern shape drawn on the mask changes, and this brings about the difficultly that problems occur with the precision of superimposition of the mask.

There are several factors involved in the change of mask flatness due to a pellicle being affixed, but it has been found that the largest factor is the flatness of the pellicle frame.

The pellicle is affixed to a mask via a mask pressure-sensitive adhesive present on one side of the pellicle frame; when the pellicle is affixed to a mask, the pellicle is usually pressed against the mask with a force in the order of 20 to 30 kgf. In general, the flatness of the mask is a few µm or less as a TIR value, and is 1 µm or less for a state-of-the-art mask, and the flatness of the pellicle frame is generally in the order of a few tens of µm, which is large compared with the mask. Because of this, when the pellicle is affixed to the mask, the flatness of the mask might change due to unevenness of the frame. Here, it might be thought that by increasing the flatness of the pellicle frame so that it is as high as the flatness of the mask it would become possible to reduce the change in flatness of the mask.

The pellicle frame is generally formed from an aluminum alloy. With regard to a pellicle frame for semiconductor lithography, the width is on the order of 150 mm, the length is on the order of 110 to 130 mm, and it is generally formed from a pellicle frame bar having a rectangular cross-section. A frame is generally prepared by cutting out a pellicle frame shape from an aluminum alloy plate or extrusion-molding an aluminum material into a frame shape, but since the width is as narrow as in the order of 2 mm and it is easy to deform, it is not easy to produce a flat frame. Because of this, it is very difficult to make the pellicle frame have a flatness of the same degree as that of the mask.

In order to prevent deformation of the mask due to deformation of the pellicle frame, JP-A-2008-65258 discloses a pellicle in which the thickness of a mask pressure-sensitive adhesive via which the pellicle is affixed to a mask is at least 0.4 mm, and a pellicle for which the modulus of elasticity at 23°C of the mask pressure-sensitive adhesive is no greater than 0.5 MPa.

In recent years, with regard to the flatness required for a mask, from a fatness of 2 µm on the pattern face the requirement is gradually becoming more strict, and for 65 nm node and beyond, 0.5 µm or less and preferably 0.25 µm is now required.

In general, the flatness of a pellicle frame is in the order of 20 to 80 µm (The description '20 to 80 µm' expressing a range of numerical values means 'not less than 20 but not more than 80'. A similar range of numerical values has the same meaning as before.), but if a pellicle employing a pellicle frame having poorer flatness than a mask is affixed to the mask, the shape of the frame is transferred to the mask, thus causing deformation of the mask. When affixing, the pellicle is pressed against the mask with a large force of about 200 to 400 N (20 to 40 kgf). Since the flatness of the mask surface is better than the flatness of the pellicle frame, when pressing of the pellicle against the mask is completed, the pellicle frame attempts to return to its original shape, and the pellicle frame thereby causes the mask to deform.

When the mask is deformed, the mask flatness can sometimes be degraded, and in this case the problem of defocusing within an exposure device occurs. On the other hand, deformation of the mask can sometimes improve the flatness, but even in this case a pattern formed on the mask surface is distorted, and as a result the problem of a pattern image replicated on a wafer by exposure being distorted occurs. Since this distortion of the pattern also occurs when the mask flatness is degraded, when the mask ends up being deformed by affixing the pellicle, the problem of the pattern image being distorted always occurs.

It is an object of the present invention to provide a pellicle for lithography that can suppress deformation of an exposure master plate due to deformation of a pellicle frame even if the pellicle is affixed to the exposure master plate.

The above-mentioned objects of the present invention have been accomplished by means (1) below. They are described together with (2) to (7), which are preferred embodiments.
(1) A pellicle for lithography comprising: a pellicle frame; a pellicle film stretched over one end face of the pellicle frame; and a pressure-sensitive adhesive layer provided on the other end face, the pressure-sensitive adhesive layer having a bubble content of 10 to 90 volume %.
(2) The pellicle for lithography according to (1), wherein the bubbles contained in the pressure-sensitive adhesive layer have a number-average diameter of 10 to 200 µm.
(3) The pellicle for lithography according to (1) or (2), wherein the pressure-sensitive adhesive layer has a thickness of at least 0.3 mm.
(4) The pellicle for lithography according to any one of (1) to (3), wherein the pressure-sensitive adhesive layer has a modulus of elasticity at 23°C of no greater than 0.6 MPa.
(5) The pellicle for lithography according to any one of (1) to (4), wherein the pressure-sensitive adhesive layer comprises a silicone pressure-sensitive adhesive.
(6) The pellicle for lithography according to any one of (1) to (4), wherein the pressure-sensitive adhesive layer comprises an acrylic pressure-sensitive adhesive.
(7) The pellicle for lithography according to any one of (1) to (6), wherein it comprises bubbles formed by thermally foaming residual solvent in the pressure-sensitive adhesive layer.

In accordance with the present invention, by reducing the apparent elasticity of the pellicle pressure-sensitive adhesive layer, distortion of a mask, etc. when affixing the pellicle to the mask, etc. can be reduced. Because of this, deformation of an exposure master plate due to deformation of the pellicle frame can be minimized. In particular, even when a pressure-sensitive adhesive of the same material is used, the apparent elasticity can be reduced. Because of this, a pattern drawn above the mask can be reproduced more precisely, thereby improving the precision with which the mask is superimposed.

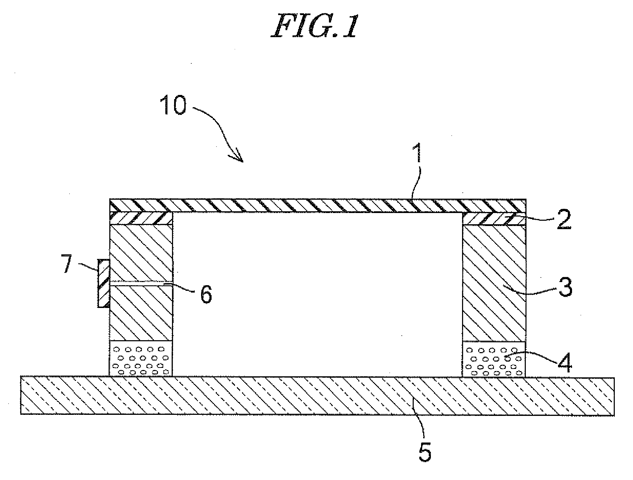

FIG. 1 is a schematic diagram showing the basic constitution of a pellicle for lithography used in the present invention.

The basic constitution of the pellicle used in the present invention is explained first by reference to FIG. 1.

As shown in FIG. 1, a pellicle 10 of the present invention is formed by stretching a pellicle film 1 over an upper end face of a pellicle frame 3 via an adhesive layer 2 for affixing the pellicle film. In this case, a foamed pressure-sensitive adhesive layer 4 for adhering the pellicle 10 to an exposure master plate (mask substrate or reticle) 5 is usually formed on a lower end face of the pellicle frame 3, and a liner (not illustrated) is detachably adhered to a lower end face of the foamed pressure-sensitive adhesive layer 4. The pellicle frame 3 may be provided with an atmospheric pressure adjustment hole (vent) 6, and further with a dust filter 7 for the purpose of removing particles.

In this case, the dimensions of these pellicle constituent members are similar to those of a conventional pellicle, for example, a pellicle for semiconductor lithography, a pellicle for a lithographic step of large liquid crystal display panel production, etc., and the materials thereof may be known materials, as described above.

The type of pellicle film is not particularly limited and, for example, an amorphous fluorine polymer, etc. that has conventionally been used for an excimer laser is used. Examples of the amorphous fluorine polymer include Cytop (product name, manufactured by Asahi Glass Co. Ltd.) and Teflon (Registered Trademark) AF (product name, manufactured by DuPont). These polymers may be used by dissolving them in a solvent as necessary when preparing the pellicle film, and may be dissolved as appropriate in, for example, a fluorine-based solvent.

With regard to the base material of the pellicle frame, a conventionally used aluminum alloy material, and preferably a JIS A7075, JIS A6061, JIS A5052 material, etc., is used, but when an aluminum alloy is used it is not particularly limited as long as the strength as a pellicle frame is guaranteed. The surface of the pellicle frame is preferably roughened by sandblasting or chemical abrasion prior to providing a polymer coating. In the present invention, a method for roughening the surface of the frame may employ a conventionally known method. It is preferable to employ a method for roughening the surface involving blasting the aluminum alloy material surface with stainless steel, carborundum, glass beads, etc., and further by chemically abrading with NaOH, etc.

With regard to an adhesive for use in the foamed pressure-sensitive adhesive layer 4, various types of adhesives may be selected as appropriate; an acrylic adhesive, an SEBS (poly(styrene-ethylene-butadiene-styrene))-based adhesive, and a silicone-based adhesive may preferably be used, and an acrylic adhesive or a silicone-based adhesive may more preferably be used.

The pellicle for lithography of the present invention is characterized by a layer of pressure-sensitive adhesion applied to the lower end face of the pellicle frame (in the present invention, also called simply a 'pressure-sensitive adhesive layer') having a bubble content of 10 to 90 volume %.

The bubble content is preferably 10 to 80 volume %, and more preferably 10 to 50 volume %.

When the bubble content is less than 10 volume %, the effect in reducing the modulus of elasticity is degraded, and when it exceeds 90 volume %, the mechanical strength tends to decrease. By making it no greater than 50 volume %, bubbles in the pressure-sensitive adhesive layer can be contained in a discontinuous and isolated state, thus giving sufficient strength, which is particularly preferable.

In the pellicle for lithography of the present invention, with regard to the size of the bubbles contained in the pressure-sensitive adhesive layer, the number-average diameter is preferably 10 to 200 µm, more preferably 10 to 120 µm, and particularly preferably 50 to 120 µm.

When above-mentioned range of numerical values is fulfilled, the pressure-sensitive adhesion effect of the pressure-sensitive adhesive layer can be maintained and the modulus of elasticity of the pressure-sensitive adhesive layer can be reduced.

The size of the bubbles can be measured by examining the cross-section of a foamed pressure-sensitive adhesive layer by means of an optical microscope, and the average value is the number-average value of 30 bubbles.

A method for making a foamed pressure-sensitive adhesive containing bubbles is not particularly limited; a known method may be employed, and examples thereof include a solvent volatilization method, a pressurization method, and a foaming agent method.

The solvent volatilization method is a method in which after a frame has been coated with a pressure-sensitive adhesive containing a solvent, the frame/pressure-sensitive adhesive is rapidly heated in a state in which there is solvent remaining. In this case, the size of the bubbles can be controlled by the residual solvent content, the rate of temperature increase during heating, etc.

In the case of the solvent volatilization method, the boiling point of a solvent that is to be volatilized is preferably in the range of 30°C to 200°C at normal pressure, and more preferably 50°C to 150°C. It is practical to make bubbles by rapidly heating a solvent having a relatively low boiling point.

A specific method for rapid heating is not particularly limited, and examples thereof include induction heating of the pellicle frame, contact of a pressure-sensitive adhesive with a high-temperature heat source, and photothermal conversion by means of a flash light source. For example, a pressure-sensitive adhesive layer containing a colorant such as carbon black and having residual solvent is flash-exposed to a xenon light source, thus rapidly heating the pressure-sensitive adhesive layer so as to carry out foaming.

The heating temperature for the pressure-sensitive adhesive layer depends on the type of the pressure-sensitive adhesive and the type of the solvent, and for example is preferably 40°C to 150°C, more preferably 50°C to 120°C, and particularly preferably 60°C to 120°C.

When foaming, the pressure may be varied from atmospheric pressure. In this case, it is preferable to reduce pressure rather than increase pressure when heating. In the case of reducing pressure, it is preferable to reduce pressure for a short period of time in synchronization with the heating.

The pressurization method is a method in which gas is dissolved in advance in the interior of a pressure-sensitive adhesive by putting it in a pressurized state, and the pressure is returned to normal pressure when a pellicle frame is coated with the pressure-sensitive adhesive. When the gas that has been trapped in the interior of the pressure-sensitive adhesive returns to normal pressure, bubbles are generated. The size of the bubbles can be controlled by selecting and adjusting the pressure, the type of gas, etc. As the type of gas, air, nitrogen gas, carbon dioxide, etc. may be used. This method is particularly effective when it is difficult for the gas to escape from the pressure-sensitive adhesive.

The foaming agent method is a method employing a system in which gas is generated by a decomposition reaction of a pressure-sensitive adhesive-forming component or an additive. In this case, bubbles can be generated even in a state in which there is no residual solvent. Also in this case, the size of the bubbles can be controlled by the type and amount of the foaming agent, the rate of temperature increase during heating, etc.

Examples of foaming agents that can be used include sodium bicarbonate, diazoaminobenzene, azodicarbonamide, and dinitrosopentamethylenetetramine.

In the pellicle for lithography of the present invention, the apparent modulus of elasticity at 23°C of the foamed pressure-sensitive adhesive layer is preferably no greater than 0.6 MPa.

The definition of apparent modulus of elasticity and a measurement method therefor are as follows.

The 'apparent modulus of elasticity' referred to here means a modulus of elasticity of a pressure-sensitive adhesive in a state in which it contains bubbles. In general, the modulus of elasticity of a pressure-sensitive adhesive containing bubbles is lower than the modulus of elasticity of a pressure-sensitive adhesive containing no bubbles.

The measurement method involves making a pressure-sensitive adhesive into sheet form, drawing the sheet from opposite ends by means of a tensile tester, and calculating the apparent modulus of elasticity from the displacement and the stress during drawing and the cross-sectional area of the sheet.

In many cases, by foaming an unfoamed pressure-sensitive adhesive, the apparent modulus of elasticity can be reduced to 1/2 to 1/5 of the modulus of elasticity of the unfoamed pressure-sensitive adhesive.

For example, in case a silicone pressure-sensitive adhesive has a modulus of elasticity of about 1 MPa, by carrying out foaming the apparent modulus of elasticity can be reduced to 0.6 MPa or less, preferably 0.1 to 0.6 MPa, more preferably 0.1 to 0.3 MPa, and particularly preferably 0.1 to 0.25 MPa.

The thickness of the pressure-sensitive adhesive layer is preferably at least 0.3 mm, more preferably 0.3 to 0.8 mm, and particularly preferably 0.3 to 0.5 mm. By increasing the thickness of the pressure-sensitive adhesive layer to some extent, even if a pellicle having poor flatness is affixed, it is possible to prevent the good flatness of an exposure master plate from being degraded.

### Examples

The present invention is explained below more specifically by reference to Examples. A 'mask' in the Examples and Comparative Example is illustrated as an example of the 'exposure master plate' and, needless to say, application to a reticle can be carried out in the same manner. The present invention is specifically explained below by way of Examples, but the present invention is not limited to the Examples below.

### (Example 1) Solvent volatilization method (1)

An aluminum alloy pellicle frame (external dimensions 149 mm × 113 mm × 4.5 mm, thickness 2 mm, flatness on the pressure-sensitive adhesive side 30 µm) was washed with pure water, an end face thereof was coated with a silicone pressure-sensitive adhesive (product name: X-40-3122A) manufactured by Shin-Etsu Chemical Co., Ltd., and immediately following this the pellicle frame was heated by electromagnetic induction heating. Heating was carried out at a rate of temperature increase of from room temperature to 80°C in 1 minute, a heated state was subsequently maintained at 80°C for 5 minutes, and residual solvent mixture (heptane and toluene) in the pressure-sensitive adhesive layer was volatilized within the pressure-sensitive adhesive. As a result of this treatment, the bubble content of the pressure-sensitive adhesive became 30 volume %, and the number-average diameter of the bubbles became 70 µm. Furthermore, the apparent modulus of elasticity at 23°C of the pressure-sensitive adhesive after foaming and curing was 0.4 MPa, and the thickness thereof was 0.3 mm.

A face of the pellicle frame opposite to the pressure-adhesive face was coated with a Cytop adhesive (product name: CTX-A) manufactured by Asahi Glass. Following this, the pellicle frame was heated at 130°C, thus curing the adhesive.

Following this, the adhesive side of the above pellicle frame was affixed to a pellicle film provided on an aluminum framework that was larger than the pellicle frame, and portions outside the pellicle frame were removed, thus completing pellicle 1.

When this pellicle 1 was affixed to a mask having a flatness of 0.25 µm, the flatness of the mask changed to 0.37 µm. The amount of change in the flatness of the mask after affixing the pellicle was as low as 0.12 µm and was not substantially greater than 0.25 µm, which was the flatness prior to affixing, this being a good result. These results are summarized in Table 1 and Table 2.

### (Example 2) Solvent volatilization method (1)

A pellicle was prepared in exactly the same manner as in Example 1 except that the conditions employed in Example 1 were changed as shown in Table 1, and the flatness before and after affixing a mask was evaluated. The results thus obtained are summarized in Table 1 and Table 2.

### (Example 3) Solvent volatilization method (2)

An aluminum alloy pellicle frame (external dimensions 149 mm × 113 mm × 4.5 mm, thickness 2 mm, flatness on the pressure-sensitive adhesive side 30 µm) was washed with pure water, an end face thereof was coated with a silicone pressure-sensitive adhesive (product name: X-40-3122A) manufactured by Shin-Etsu Chemical Co., Ltd., immediately following this the pressure-sensitive adhesive layer was contacted with a 75 µm thick separator laid on an aluminum plate heated at 80°C, and the contact was maintained in this state for 2 hours. As a result of this treatment, the bubble content of the pressure-sensitive adhesive became 1D volume %, and the number-average diameter of the bubbles became 120 µm. Furthermore, the apparent modulus of elasticity of the pressure-sensitive adhesive after curing was 0.6 MPa, and the thickness thereof was 0.3 mm.

A face of the pellicle frame opposite to the pressure-adhesive face was coated with a Cytop adhesive (product name: CTX-A) manufactured by Asahi Glass. Following this, the pellicle frame was heated at 130°C, thus curing the adhesive.

Following this, the adhesive side of the above pellicle frame was affixed to a pellicle film provided on an aluminum framework that was larger than the pellicle frame, and portions outside the pellicle frame were removed, thus completing pellicle 1.

When this pellicle 1 was affixed to a mask having a flatness of 0.25 µm, the flatness of the mask changed to 0.45 µm. The amount of change in the flatness of the mask after affixing the pellicle was as low as 0.20 µm, this being a good result. These results are summarized in Table 1 and Table 2.

### (Example 4) Solvent volatilization method (3)

A pellicle was prepared in exactly the same manner as in Example 3 except that the conditions employed in Example 3 were changed as shown in Table 1, and the flatness before and after affixing a mask was evaluated. The results thus obtained are summarized in Table 1 and Table 2.

### (Example 5) Pressurization method

An aluminum alloy pellicle frame (external dimensions 149 mm × 113 mm × 4.5 mm, thickness 2 mm, flatness on the pressure-sensitive adhesive side 30 µm) was washed with pure water, and an end face thereof was coated with an acrylic pressure-sensitive adhesive (product name: Coponyl 5672) manufactured by The Nippon Synthetic Chemical Industry Co., Ltd. The pressure-sensitive adhesive was mixed in a syringe in advance, it was pressurized at 500 kPa for 30 minutes by feeding in pressurized air, and the frame was coated therewith while maintaining the pressure. Since the pressure-sensitive adhesive was depressurized to normal pressure during coating, air trapped in the pressure-sensitive adhesive became fine bubbles.

A face of the pellicle frame opposite to the pressure-adhesive face was coated with a Cytop adhesive (product name: CTX-A) manufactured by Asahi Glass. Following this, the pellicle frame was heated at 130°C, thus curing the adhesive.

As a result of this treatment, the bubble content of the pressure-sensitive adhesive became 30 volume %, and the number-average diameter of the bubbles became 10 µm. Furthermore, the apparent modulus of elasticity of the pressure-sensitive adhesive after curing was 0.25 MPa, and the thickness thereof was 0.4 mm.

Following this, the adhesive side of the above pellicle frame was affixed to a pellicle film provided on an aluminum framework that was larger than the pellicle frame, and portions outside the pellicle frame were removed, thus completing pellicle 1.

When this pellicle 1 was affixed to a mask having a flatness of 0.25 µm, the flatness of the mask changed to 0.30 µm. The amount of change in the flatness of the mask after affixing the pellicle was as low as 0.05 µm, this being a very good result. These results are summarized in Table 1 and Table 2.

### (Example 6) Pressurization method

A pellicle was prepared in exactly the same manner as in Example 5 except that the conditions employed in Example 5 were changed as shown in Table 1, and the flatness before and after affixing a mask was evaluated. The results thus obtained are summarized in Table 1.

### (Example 7) Foaming agent method

An aluminum alloy pellicle frame (external dimensions 149 mm × 113 mm × 4.5 mm, thickness 2 mm, flatness on the pressure-sensitive adhesive side 30 µm) was washed with pure water, and an end face thereof was coated with a silicone pressure-sensitive adhesive (product name: X-40-3122A) manufactured by Shin-Etsu Chemical Co., Ltd. that had been mixed with a foaming agent (product name: Cellmic) manufactured by Sankyo Kasei Co., Ltd. After the coating, it was allowed to stand at room temperature for 3 hours and slowly heated to 134°C to evaporate the solvent. Following this, the frame was heated to 80°C to thus decompose the foaming agent, thereby generating bubbles in the pressure-sensitive adhesive.

A face of the pellicle frame opposite to the pressure-adhesive face was coated with a Cytop adhesive (product name: CTX-A) manufactured by Asahi Glass. Following this, the pellicle frame was heated at 130°C, thus curing the adhesive.

The bubble content of the pressure-sensitive adhesive became 50 volume %, and the number-average diameter of the bubbles became 200 µm. Furthermore, the apparent modulus of elasticity at 23°C of the pressure-sensitive adhesive after foaming and curing was 0.18 MPa, and the thickness thereof was 0.5 mm.

Following this, the adhesive side of the above pellicle frame was affixed to a pellicle film provided on an aluminum framework that was larger than the pellicle frame, and portions outside the pellicle frame were removed, thus completing pellicle 1.

When this pellicle 1 was affixed to a mask having a flatness of 0.25 µm, the flatness of the mask changed to 0.29 µm. The amount of change in the flatness of the mask after affixing the pellicle was as low as 0.04 µm, this being a very good result. These results are summarized in Table 1 and Table 2.

In Table 2, the modulus of elasticity of the silicone pressure-sensitive adhesive in the Comparative Example means the modulus of elasticity of the pressure-sensitive adhesive silicone itself.

**(Table 1)**

| Example | Pressure-sensitive adhesive | Foaming method | Bubble content | Average bubble size | Conditions |
|---|---|---|---|---|---|
| | | | (%) | (µm) | |
| 1 | Silicone | Volatilization 1 | 30 | 70 | Temperature increase to 80°C in 1 min + 80°C 5 min |
| 2 | Silicone | Volatilization 1 | 90 | 100 | Temperature increase to 120°C in 30 sec + 120°C 10 min |
| 3 | Silicone | Volatilization 2 | 10 | 120 | Plate contact 80°C |
| 4 | Silicone | Volatilization 2 | 30 | 100 | Plate contact 100°C |
| 5 | Acrylic | Pressurization | 30 | 10 | Pressurization 500 kPa |
| 6 | Acrylic | Pressurization | 50 | 50 | Pressurization 800 kPa |
| 7 | Silicone + foaming agent | Foaming agent | 50 | 200 | Foaming agent heating 180°C |
| Comp. | Silicone | - | 0 | - | |

**(Table 2)**

| Example | Thickness | Apparent modulus of elasticity | Mask flatness (µm) | | |
|---|---|---|---|---|---|
| | (mm) | (MPa) | Before | After | Change |
| 1 | 0.3 | 0.4 | 0.25 | 0.37 | 0.12 |
| 2 | 0.3 | 0.1 | 0.25 | 0.27 | 0.02 |
| 3 | 0.3 | 0.6 | 0.25 | 0.45 | 0.20 |
| 4 | 0.5 | 0.4 | 0.25 | 0.32 | 0.07 |
| 5 | 0.4 | 0.25 | 0.25 | 0.30 | 0.05 |
| 6 | 0.4 | 0.15 | 0.25 | 0.28 | 0.03 |
| 7 | 0.5 | 0.18 | 0.25 | 0.29 | 0.04 |
| Comp. | 0.3 | 1.0 | 0.25 | 0.55 | 0.30 |

FIG. 1; A schematic diagram showing the basic constitution of a pellicle for lithography used in the present invention.
- 1:: Pellicle film
- 2:: Adhesive layer
- 3:: Pellicle frame
- 4:: Foamed pressure-sensitive adhesive layer
- 5:: Exposure master plate
- 6:: Atmospheric pressure adjustment hole (vent)
- 7:: Dust filter
- 10:: Pellicle

## Claims

1. A pellicle for lithography comprising: a pellicle frame; a pellicle film stretched over one end face of the pellicle frame; and a pressure-sensitive adhesive layer provided on the other end face, the pressure-sensitive adhesive layer having a bubble content of 10 to 90 volume %.

2. The pellicle for lithography according to Claim 1, wherein the bubble content is 10 to 50 volume %.

3. The pellicle for lithography according to Claim 1 or 2, wherein the bubbles contained in the pressure-sensitive adhesive layer have a number-average diameter of 10 to 200 µm.

4. The pellicle for lithography according to any one of Claims 1 to 3, wherein the pressure-sensitive adhesive layer has a thickness of 0.3 to 0.8 mm.

5. The pellicle for lithography according to any one of Claims 1 to 4, wherein the pressure-sensitive adhesive layer has a thickness of 0.3 to 0.5 mm.

6. The pellicle for lithography according to any one of Claims 1 to 5, wherein the pressure-sensitive adhesive layer has a modulus of elasticity at 23°C of no greater than 0.6 MPa.

7. The pellicle for lithography according to Claim 6, wherein the modulus of elasticity is 0.1 to 0.6 MPa.

8. The pellicle for lithography according to Claims 6 or 7, wherein the modulus of elasticity is 0,1 to 0.3 MPa.

9. The pellicle for lithography according to any one of Claims 1 to 8, wherein the pressure-sensitive adhesive layer comprises a silicone pressure-sensitive adhesive.

10. The pellicle for lithography according to any one of Claims 1 to 8, wherein the pressure-sensitive adhesive layer comprises an acrylic pressure-sensitive adhesive.

11. The pellicle for lithography according to any one of Claims 1 to 10, wherein the pressure-sensitive adhesive layer comprises bubbles formed by thermally foaming residual solvent in the pressure-sensitive adhesive layer, bubbles formed by foaming under normal pressure air that has been trapped under increased pressure in the pressure-sensitive adhesive layer, or bubbles formed by thermal decomposition of a foaming agent in the pressure-sensitive adhesive layer.

12. The pellicle for lithography according to Claim 11, wherein the pressure-sensitive adhesive layer comprises bubbles formed by thermally foaming residual solvent in the pressure-sensitive adhesive layer.
